# FASCICULE DE BREVET EUROPEEN

(11) **EP 0 736 694 B1**
(45) Date de publication et mention de la délivrance du brevet: **20.12.2000**
(21) Numéro de dépôt: 96400726.4
(22) Date de dépôt: 04.04.1996
(51) Int. Cl.: F16B 5/06

(54) **Assemblage indémontable par encliquetage**
Unlösbare Rastverbindung
Non-disconnectable snap lock assembly

(30) Priorité: 06.04.1995 FR 9504108
(43) Date de publication de la demande: 09.10.1996
(73) Titulaire: PEGUFORM FRANCE, 01100 Oyonnax (FR)
(72) Inventeur: Barbe, Patrick, 39230 Sellieres (FR)
(74) Mandataire: Martin, Jean-Jacques

(56) Documents cités:
- EP-A- 0 409 347
- DE-A- 3 346 540
- DE-A- 3 523 216
- DE-A- 4 111 245
- DE-U- 9 201 258

## Description

La présente invention concerne de manière générale les assemblages par encliquetage de deux pièces en matière plastique et plus particulièrement un ensemble de deux éléments d'assemblage en matière plastique aptes à être assemblés de manière indémontable selon une direction X suivant le préambule de la revendication 1 (DE-U-920158).

L'invention trouve une application particulièrement avantageuse dans le domaine de l'éléctroménager, pour assembler par exemple une porte et une contre-porte d'un sèche-linge ou d'un lave linge, ou bien dans le domaine de la construction automobile pour assembler une grille sur un barreau de calandre, ou encore des éléments rapportés sur un pare-chocs, ou une planche de bord.

On connaît déjà un ensemble indémontable de ce type, dans lequel le premier élément d'assemblage, appelé communément dent d'encliquetage, comporte un corps qui s'étend selon la direction X d'assemblage et une tête d'assemblage pourvue d'une première surface d'assemblage s'étendant selon une direction perpendiculaire à ladite direction X d'assemblage. Cette première surface d'assemblage est destinée à coopérer avec une seconde surface d'assemblage du deuxième élément d'assemblage, cette seconde surface d'assemblage s'étendant également selon une direction perpendiculaire à la direction X d'assemblage.

L'inconvénient majeur d'un tel ensemble réside dans la réalisation par moulage desdits éléments d'assemblage et en particulier de la dent d'encliquetage. En effet, du fait que cette dent d'encliquetage comporte une surface d'assemblage s'étendant selon une direction perpendiculaire à la direction principale du corps, il est généralement nécessaire d'utiliser pour sa réalisation un moule spécialement conçu pour cette réalisation, ce qui entraîne un surcoût de fabrication. Les moules spécialement conçus pour réaliser de telles pièces, sont des moules qui lors du démoulage se séparent en plusieurs parties avec un mouvement relatif par rapport aux pièces. On peut alors aisément démouler de telles pièces sans solliciter mécaniquement celles-ci.

La présente invention propose un nouvel ensemble de deux éléments d'assemblage destinés à être assemblés de manière indémontable selon une direction X, dans lequel les éléments d'assemblage comportent des surfaces d'assemblage orientées de sorte que le démoulage de ces éléments d'assemblage peut être réalisé aisément, à l'aide de moules conventionnels sans mouvement relatif supplémentaire des éléments d'assemblage par rapport aux moules.

En particulier, selon l'invention, les première et seconde surfaces d'assemblage desdits éléments d'assemblage sont orientées selon une direction X₁ qui forme un angle α non nul avec une direction Y perpendiculaire à ladite direction X, et il est prévu un téton de verrouillage apte à exercer sur le deuxième élément d'assemblage une force de poussée en direction du premier élément d'assemblage lorsque lesdits éléments d'assemblage en position assemblée coopérent l'un avec l'autre, afin de les maintenir dans cette position, l'angle α d'orientation desdites surfaces d'assemblage étant supérieur à environ 30° et de préférence égal à environ 45°.

La description qui va suivre en regard des dessins annexés, donnés à titre d'exemples non limitatifs, fera bien comprendre en quoi consiste l'invention et comment elle peut être réalisée.
Sur les figures annexées :
- la figure 1 est une vue schématique en perspective de l'ensemble indémontable conforme à l'invention,
- la figure 2 est une vue de côté du deuxième élément d'assemblage de l'ensemble de la figure 1,
- la figure 3 est une vue de côté en coupe verticale d'une variante de réalisation de l'ensemble indémontable assemblé de la figure 1.

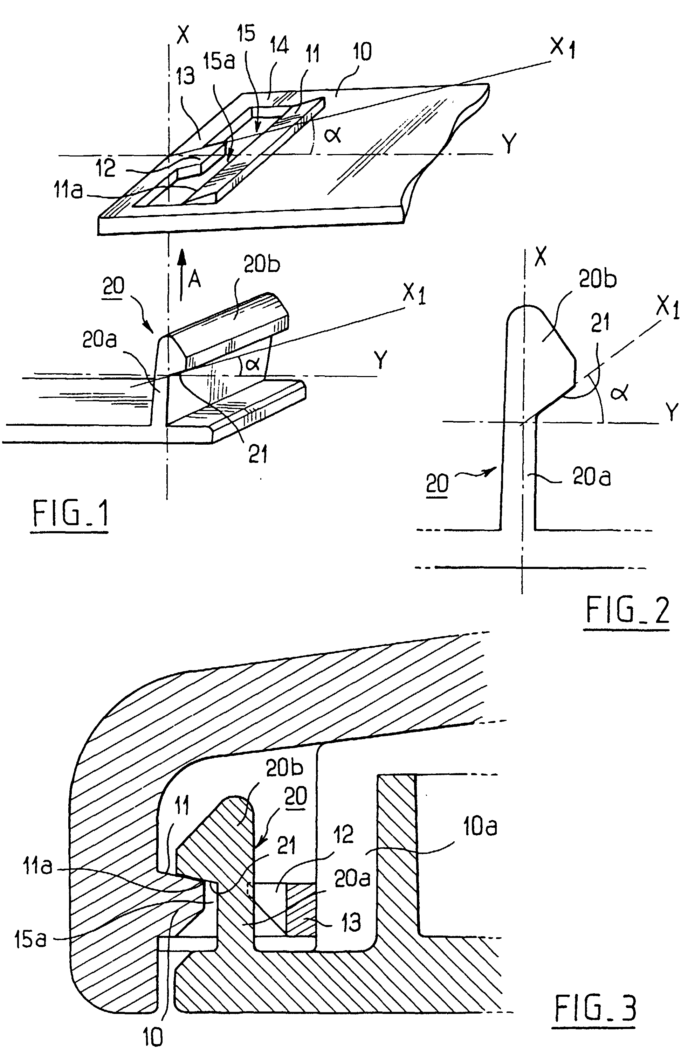

Sur la figure 1, on a représenté un premier mode de réalisation d'un ensemble de deux éléments d'assemblage 10, 20 réalisé en matière plastique moulée. Ces deux éléments d'assemblage 10, 20 sont aptes à être assemblés de manière indémontable selon une direction X.

Le premier élément d'assemblage 10 est destiné à être solidarisé avec une pièce à assembler et comporte une surface plane d'assemblage 11 orientée selon une direction X₁ formant un angle α non nul par rapport à la direction Y perpendiculaire à ladite direction X. Cet angle α est avantageusement supérieur à environ 30° et de préférence égal à 45°. Bien entendu, on peut prévoir des angles α d'inclinaison plus faibles de l'ordre de quelques degrés.

En outre, ce premier élément d'assemblage 10 comprend un cadre 14 qui définit une ouverture 15 de forme rectangulaire. La surface d'assemblage 11 du premier élément d'assemblage 10 est positionnée sur un grand côté 11a dudit cadre 14. L'autre grand côté parallèle 13 constitue une branche présentant une certaine flexibilité. Cette branche flexible 13 porte un téton de verrouillage 12 positionné dans une région médiane de ladite branche flexible 13 et s'étendant à partir de ladite branche flexible 13 perpendiculairement à celle-ci dans ladite ouverture 15 en direction de ladite surface d'assemblage 11.

Entre l'extrémité du téton de verrouillage 12 et le bord de la surface d'assemblage 11 subsiste alors un passage étroit 15a, dans lequel est destinée à s'engager la tête 20b du deuxième élément d'assemblage 20, comme cela sera décrit ultérieurement.

L'ensemble représenté sur la figure 1 comporte un deuxième élément d'assemblage 20 (voir figures 1 et 2), appelé communément dent d'encliquetage, qui comprend un corps 20a s'étendant selon ladite direction X d'assemblage, et une tête 20b munie d'une surface plane d'assemblage 21 destinée à coopérer avec la surface d'assemblage 11 du premier élément d'assemblage 10 lors de l'assemblage des deux éléments d'assemblage 10, 20 selon ladite direction X. Cette seconde surface d'assemblage 21 est orientée selon la même direction X₁ que la première surface d'assemblage 11 du premier élément d'assemblage 10. Plus particulièrement, cette direction X₁ fait un angle α non nul, avantageusement supérieur à environ 30° et de préférence égal à 45°, avec la direction Y perpendiculaire à ladite direction X d'assemblage. Comme le montrent les figures 1 et 2, le deuxième élément d'assemblage 20 est solidaire d'une pièce à assembler. Il émerge ici perpendiculairement de ladite pièce.

Selon une variante de réalisation représentée sur la figure 3, la branche flexible 13 qui porte le téton de verrouillage 12 du premier élément d'assemblage 10, ne fait pas partie d'un cadre entourant ladite première surface d'assemblage 11, mais est solidaire d'un montant 10a indépendant de sorte que ladite branche flexible 13 est positionnée parallèlement au bord 11a de ladite première surface d'assemblage 11, le téton de verrouillage 12 s'étendant en direction de ladite première surface d'assemblage 11 en ménageant un passage étroit 15a entre celui-ci et ladite surface d'assemblage 11 pour l'introduction du deuxième élément d'assemblage 20, en vue de l'assemblage des premier et deuxième éléments d'assemblage 10, 20. Ce passage 15a est plus étroit que la largeur de la tête 20b du deuxième élément d'assemblage 20.

L'assemblage de l'ensemble de la figure 1 ou 3 est réalisé de la manière suivante.

La tête 20b du deuxième élément d'assemblage 20 est introduite selon la direction X, avec la deuxième surface d'assemblage 21 tournée du côté de la première surface d'assemblage 11, dans le passage étroit 15a défini entre le téton de verrouillage 12 et la première surface d'assemblage 11 du premier élément d'assemblage 10. Pour permettre l'introduction de la tête d'assemblage 20b du deuxième élément d'assemblage 20 au travers de ce passage étroit 15a, la branche flexible 13 du premier élément d'assemblage 10, se déforme légèrement élastiquement pour agrandir ledit passage 15a (et selon le mode de réalisation de la figure 1, l'ouverture 15). La flexion élastique de la branche flexible 13 autorise la tête 20a du deuxième élément d'assemblage 20 à passer le point dur créé au niveau du téton de vérrouillage 12.

Lorsque la tête 20b du deuxième élément d'assemblage 20 a passé le point dur situé au niveau du téton de verrouillage 12, la flexibilité de la branche 13 permet audit téton de verrouillage 12 de prendre appui sur le corps 20a du deuxième élément d'assemblage 20 se trouvant entre le téton de verrouillage 12 et la surface d'assemblage 11, pour exercer une force de poussée sur ce deuxième élément d'assemblage 20 en direction du premier élément d'assemblage 10 de sorte que les première et deuxième surfaces d'assemblage 11, 21 soient maintenues en appui l'une contre l'autre de manière définitive. Dans cette position assemblée, il n'est plus possible de désolidariser le premier élément d'assemblage 10 du deuxième élément d'assemblage 20 sans détériorer un des deux éléments d'assemblage 10, 20 ou ledit téton de verrouillage 12.

La présente invention n'est nullement limitée aux modes de réalisation décrits et représentés, mais l'homme du métier pourra envisager toute variante conforme à son esprit.

## Revendications

1. Ensemble de deux éléments d'assemblages en matière plastique (10,20), aptes à être assemblés de manière indémontable selon une direction X, le premier élément d'assemblage (10) étant pourvu d'une première surface d'assemblage (11) destinée à coopérer avec une seconde surface d'assemblage (21) du deuxième élément d'assemblage (20), un téton de verrouillage (12) étant prévu pour exercer sur le deuxième élément d'assemblage (20) une force de poussée en direction du premier élément d'assemblage (10) lorsque les deux éléments d'assemblage (10,20) en position assemblée coopèrent l'un avec l'autre afin de les maintenir dans cette position, caractérisé en ce que les première et seconde surfaces d'assemblage (11,21) sont orientées selon une direction X₁, qui forme un angle a supérieur à environ 30° avec une direction Y perpendiculaire à ladite direction X.

2. Ensemble selon la revendication 1, caractérisé en ce que le téton de verrouillage (12) est solidaire d'une branche flexible (13) positionnée parallèlement au bord (11a) de ladite première surface d'assemblage (11), et apte à se déformer élastiquement lors de l'assemblage des premier et deuxième éléments d'assemblage (10,20) pour permettre le positionnement du téton de verrouillage (12) en appui sur le deuxième élément d'assemblage (20).

3. Ensemble selon la revendication 2, caractérisé en ce que le téton de verrouillage (12) s'étend à partir de ladite branche flexible (13) en direction de ladite première surface (11) du premier élément d'assemblage (10), un passage étroit (15a) étant ménagé entre ledit téton de verrouillage (12) et ladite première surface d'assemblage (11), pour l'introduction du deuxième élément d'assemblage (20).

4. Ensemble selon la revendication 2 ou 3, caractérisé en ce que le premier élément d'assemblage (10) comporte un cadre (14) qui définit une première ouverture (15) dans laquelle est destiné à s'engager le deuxième élément d'assemblage (20) lors de l'assemblage des premier et deuxième éléments d'assemblage (10,20), un côté du cadre (14) portant la première surface d'assemblage (11) dudit premier élément d'assemblage (10) et l'autre côté parallèle du cadre (14) formant la branche flexible (13) munie dudit téton de verrouillage (12) s'étendant à partir de ladite branche flexible (13), perpendiculairement à cette dernière dans ladite ouverture (15) en direction de la première surface d'assemblage (11) tout en ménageant un passage étroit (15a) entre ledit téton de verrouillage (12) et ladite première surface d'assemblage (11) pour l'introduction du deuxième élément d'assemblage (20).

5. Assemblage selon l'une quelconque des revendications 1 à 4, caractérisé en ce que l'angle α formé entre ladite direction X₁ et ladite direction Y est égal à environ 45°.

## Patentansprüche

1. Baugruppe aus zwei Kunststoff-Montageelementen (10, 20), die zum unlösbaren Zusammenbau in einer Richtung X eingerichtet sind, wobei das erste Montageelement (10) mit einer ersten Montage-Oberfläche (11) versehen ist, die zur Zusammenwirkung mit einer zweiten Montage-Oberfläche (21) des zweiten Montageelements (20) bestimmt ist, und wobei ein Verriegelungsansatz (12) vorgesehen ist, um auf das zweite Montageelement (20) eine Schubkraft in Richtung des ersten Montageelements (10) auszuüben, wenn die beiden Montageelemente (10, 20) in Zusammenbaulage gegenseitig zusammenwirken, um sie in dieser Lage zu halten, dadurch gekennzeichnet, daß die erste und zweite Montage-Oberfläche (11, 21) in einer Richtung X₁ orientiert sind, die einen Winkel α, der größer ist als etwa 30°, zu einer Richtung Y bildet, die senkrecht zur genannten Richtung X steht.

2. Baugruppe nach Anspruch 1, dadurch gekennzeichnet, daß der Verriegelungsansatz (12) fest an einem flexiblen Arm (13) ausgebildet ist, der parallel zum Rand (lla) der genannten ersten Montage-Oberfläche (11) angeordnet ist, und der dazu eingerichtet ist, sich während des Zusammenbaus des ersten und zweiten Montageelements (10, 20) elastisch zu verformen, um die Positionierung des Verriegelungsansatzes (12) in Anlage gegen das zweite Montageelement (20) zu gestatten.

3. Baugruppe nach Anspruch 2, dadurch gekennzeichnet, daß sich der Verriegelungsansatz (12) vom genannten flexiblen Arm (13) ausgehend in Richtung der genannten ersten Oberfläche (11) des ersten Montageelements (10) erstreckt, wobei ein ein schmaler Kanal (15a) zwischen dem genannten Verriegelungsansatz (12) und der genannten ersten Montage-Oberfläche (11) zum Einführen des zweiten Montageelements (20) eingebracht ist.

4. Baugruppe nach Anspruch 2 oder 3, dadurch gekennzeichnet, daß das erste Montageelement (10) einen Rahmen (14) aufweist, der eine erste Öffnung (15) bildet, und daß das zweite Montageelement (20) dazu bestimmt ist, während des Zusammenbaus des ersten und zweiten Montageelements (10, 20) in diese einzugreifen, wobei eine Seite des Rahmens (14) die erste Montage-Oberfläche (11) des genannten, ersten Montageelements (10) trägt und die andere, parallele Seite des Rahmens (14) den flexiblen Arm (13) bildet, der mit dem genannten Verriegelungsansatz (12) versehen ist, der sich vom genannten, flexiblen Arm (13) ausgehend senkrecht zu diesem in der genannten Öffnung (15) in Richtung der ersten Montage-Oberfläche (11) erstreckt, während er gleichzeitig einen schmalen Kanal (15a) zwischen dem genannten Verriegelungsansatz (12) und der genannten, ersten Montage-Oberfläche (11) zum Einbringen des zweiten Montageelements (20) ausspart.

5. Baugruppe nach irgendeinem der Ansprüche 1 bis 4, dadurch gekennzeichnet, daß der Winkel α, der zwischen der genannten Richtung X₁ und der genannten Richtung Y gebildet ist, gleich etwa 45° ist.

## Claims

1. An assembly of two assembly elements of plastics material (10, 20) suitable for being assembled together in non-releasable manner in a direction X, the first assembly element (10) being provided with a first assembly surface (11) for co-operating with a second assembly surface (21) belonging to the second assembly element (20), a locking stud (12) being provided to exert a thrust force on the second assembly element (20) directed towards the first assembly element (10) when the two assembly elements (10, 20) in the assembled position co-operate with each other in order to maintain them in this position, the assembly being characterized in that the first and second assembly surfaces (11, 21) are oriented in a direction X₁ which forms an angle α greater than about 30° with a direction Y that is perpendicular to said direction X.

2. An assembly according to claim 1, characterized in that the locking stud (12) that is secured to a flexible branch (13) extending parallel to the edge (11 a) of said first assembly surface (11) and that is suitable for deforming elastically while the first and second assembly elements (10, 20) are being assembled together so as to enable the locking stud (12) to be positioned so that it bears against the second assembly element (20).

3. An assembly according to claim 2, characterized in that the locking stud (12) extends from said flexible branch (13) towards said first surface (11) of the first assembly element (10), a narrow passage (15a) being provided between said locking stud (12) and said first assembly surface (11) for insertion of the second assembly element (20).

4. An assembly according to claim 2 or 3, characterized in that the first assembly element (10) has a frame (14) which defines a first opening (15) into which the second assembly element (20) is designed to be engaged while the first and second assembly elements (10, 20) are being assembled together, one side of the frame (14) carrying the first assembly surface (11) of said first assembly element (10), and the parallel other side of the frame (14) forming the flexible branch (13) provided with said locking stud (12) extending from said flexible branch (13) perpendicularly thereto into said opening (15) towards the first assembly surface (11) while leaving a narrow passage (15a) between said locking stud (12) and said first assembly surface (11) for insertion of the second assembly element (20).

5. An assembly according to any one of claims 1 to 4, characterized in that the angle α formed between said direction X₁ and said direction Y is equal to about 45°.
